# EUROPEAN PATENT APPLICATION

(11) **EP 2 144 306 A1**
(43) Date of publication of application: **13.01.2010**
(21) Application number: 09164924.4
(22) Date of filing: 08.07.2009
(51) Int. Cl.: H01L 33/00

(54) **Group III nitride semiconductor light-emitting device and epitaxial wafer**

(30) Priority: 09.07.2008 JP 2008179435
(71) Applicant: Sumitomo Electric Industries, Ltd., Osaka-shi, Osaka 541-0041 (JP)
(72) Inventor: Akita, Katsushi, Itami-shi Hyogo 664-0016 (JP); Enya, Yohei, Itami-shi Hyogo 664-0016 (JP); Kyono, Takashi, Itami-shi Hyogo 664-0016 (JP); Ueno, Masaki, Itami-shi Hyogo 664-0016 (JP)
(74) Representative: Grünecker, Kinkeldey, Stockmair & Schwanhäusser Anwaltssozietät

(57) **Abstract**

The group III nitride semiconductor light-emitting device (11) includes: a gallium nitride based semiconductor region of n-type (13); a p-type gallium nitride based semiconductor region (15); a hole-blocking layer (17); and an active layer (19). The gallium nitride based semiconductor region of n-type has a primary surface (13a), and the primary surface extends on a predetermined plane. The c-axis of the gallium nitride based semiconductor region tilts from a normal line of the predetermined plane. The hole-blocking layer comprises a first gallium nitride based semiconductor. The band gap of the hole-blocking layer is greater than the band gap of the gallium nitride based semiconductor region, and the thickness of the hole-blocking layer is less than the thickness of the gallium nitride based semiconductor region. The active layer comprises a gallium nitride semiconductor. The active layer is provided between the p-type gallium nitride based semiconductor region and the hole-blocking layer. The hole-blocking layer and the active layer is provided between the primary surface of the gallium nitride based semiconductor region and the p-type gallium nitride based semiconductor region. The band gap of the hole-blocking layer is greater than a maximum band gap of the active layer.

## Description

### Background of the Invention

### Field of the Invention

The present invention relates to a group III nitride semiconductor light-emitting device and an epitaxial wafer.

### Description of the Related Art

Patent publication 1 (Japanese Unexamined Patent Application Publication No. 6-260683) discloses a blue light emitting diode of a double heterostructure. A low-temperature buffer layer composed of GaN is provided on a substrate composed of a different material, for example, sapphire, SiC, or ZnO. An n-type GaN layer (first cladding layer), a Zn-doped InGaN layer (emitting layer), and a Mg-doped p-type GaN layer (second cladding layer) are grown in sequence on the buffer layer.

### Summary of the Invention

The blue light emitting device disclosed in Patent publication 1 includes the InGaN emitting layer grown on a c-plane sapphire substrate. A group III nitride semiconductor light-emitting device such as a blue light emitting diode can be formed on a c-plane GaN substrate. In recent years, group III nitride semiconductor light-emitting devices can be produced on semipolar or nonpolar GaN substrates, as well as polar c-plane substrates. According to experimental results conducted by the inventors, the behavior of holes in a gallium nitride semiconductor grown on a semipolar surface is different from that in a gallium nitride semiconductor grown on the polar surface. A further study by the inventors shows that the diffusion length of holes in a gallium nitride semiconductor on the semipolar surface is greater than that in a gallium nitride semiconductor on the c-plane. Accordingly, in light emitting diodes prepared on semipolar substrates, holes injected into active layers may overflow from the active layers, resulting in poor quantum efficiency of light emission.

It is an object of the present invention to provide a group III nitride semiconductor light-emitting device that can reduce the overflow of holes from an active layer to obtain enhanced quantum efficiency, and it is another object to provide an epitaxial wafer for the group III nitride semiconductor light-emitting device.

One aspect according to the present invention is directed to a group III nitride semiconductor light-emitting device. The group III nitride semiconductor light-emitting device includes: (a) an n-type gallium nitride based semiconductor region; (b) a p-type gallium nitride based semiconductor region; (c) a hole-blocking layer; and (d) an active layer. The n-type gallium nitride based semiconductor region of n-type has a primary surface, and the primary surface extends along a predetermined plane. The c-axis of the n-type gallium nitride based semiconductor region tilts from a normal line of the predetermined plane. The hole-blocking layer comprises a first gallium nitride based semiconductor. The band gap of the hole-blocking layer is greater than the band gap of the gallium nitride based semiconductor region, and the thickness of the hole-blocking layer is less than that of the gallium nitride based semiconductor region. The active layer comprises a gallium nitride semiconductor. The active layer is provided between the p-type gallium nitride based semiconductor region and the hole-blocking layer. The hole-blocking layer and the active layer is provided between the primary surface of the n-type gallium nitride based semiconductor region and the p-type gallium nitride based semiconductor region. The band gap of the hole-blocking layer is greater than a maximum band gap of the active layer.

In the group III nitride semiconductor light-emitting device in which the active layer is provided between the p-type gallium nitride based semiconductor region and the hole-blocking layer, the p-type gallium nitride based semiconductor region supplies holes to the active layer. Since the band gap of the hole-blocking layer is greater than that of the gallium nitride based semiconductor region, the hole-blocking layer functions as a barrier to holes in the active layer. As a result, the hole-blocking layer can reduce the number of holes that overflow from the active layer and reach the n-type gallium nitride based semiconductor region. Furthermore, since the thickness of the hole-blocking layer is less than the thickness of the gallium nitride based semiconductor region, the hole-blocking layer does not exhibit high resistance to electrons fed from the n-type gallium nitride based semiconductor region to the active layer.

In the group III nitride semiconductor light-emitting device of the present invention, the tilt angle defined by the c-axis of the gallium nitride based semiconductor region and the normal line of the predetermined plane may be in the range of 10 degrees to 80 degrees.

In the group III nitride semiconductor light-emitting device of the present invention, preferably, the thickness of the hole-blocking layer may be equal to or more than 5 nanometers. The group III nitride semiconductor light-emitting device does not cause the tunneling of holes through the hole-blocking layer.

In the group III nitride semiconductor light-emitting device of the present invention, preferably, a thickness of the hole-blocking layer may be 50 nm or less. In the group III nitride semiconductor light-emitting device, the hole-blocking layer does not have high resistance to electron flow fed from the n-type gallium nitride based semiconductor region to the active layer.

In the group III nitride semiconductor light-emitting device of the present invention, preferably, the hole-blocking layer may be doped with an n-type dopant. In the group III nitride semiconductor light-emitting device, doping the hole-blocking layer with the n-type dopant can reduce its resistance.

In the group III nitride semiconductor light-emitting device of the present invention, preferably, the first gallium nitride based semiconductor of the hole-blocking layer may comprise gallium, indium and aluminum as group III constituents. In the group III nitride semiconductor light-emitting device, the lattice constant of the hole-blocking layer composed of such a quaternary mixed crystal is made close to a desired lattice constant, in addition to the barrier of the hole-blocking layer against holes.

In the group III nitride semiconductor light-emitting device of the present invention, the first gallium nitride based semiconductor of the hole-blocking layer may comprise indium as a group III constituent, the indium content of the first gallium nitride based semiconductor is greater than zero and equal to or less than 0.3.

In the group III nitride semiconductor light-emitting device of the present invention, the hole-blocking layer may include an AlGaN layer. Materials for the hole-blocking layer may be AlGaN, as well as InAlGaN. AlGaN can provide a hole-blocking layer having a large band gap.

In the group III nitride semiconductor light-emitting device of the present invention, the first gallium nitride based semiconductor of the hole-blocking layer may comprise aluminum as a group III constituent. Preferably, the aluminum content of the hole-blocking layer is more than zero and equal to or less than 0.5.

The group III nitride semiconductor light-emitting device of the present invention may further include an electron-blocking layer, the electron-blocking layer comprises a second gallium nitride based semiconductor, the electron-blocking layer is provided between the active layer and the p-type gallium nitride based semiconductor region, and a thickness of the hole-blocking layer is less than that of the electron-blocking layer.

In the group III nitride semiconductor light-emitting device of the present invention, the group III nitride semiconductor light-emitting device may be a light emitting diode. Unlike the semiconductor laser, the light emitting diode does not include an optical cladding layer, and accordingly the hole-blocking layer is effective in reducing the overflow of holes.

The group III nitride semiconductor light-emitting device of the present invention may further include a substrate having a primary surface comprising a gallium nitride based semiconductor. The primary surface is semipolar. The gallium nitride based semiconductor region is provided between the substrate and the hole-blocking layer. The group III nitride semiconductor light-emitting device is prepared on the semipolar GaN primary surface, and does not exhibit the noticeable behavior of holes which is inherent in the semipolar.

In the group III nitride semiconductor light-emitting device of the present invention, the substrate may comprise GaN. The group III nitride semiconductor light-emitting device can be produced with a semipolar GaN wafer having a large diameter, and is made the hole behavior inherent in the semipolar characteristics moderate.

In the group III nitride semiconductor light-emitting device of the present invention, preferably, the active layer has a quantum well structure including one or more well layers and barrier layers, the number of the well layers is four or less. An increased number of well layers in the group III nitride semiconductor light-emitting device may impair the crystal quality of the well layers. On the other hand, a decreased number of well layers leads to noticeable effect of overflow of holes.

In the group III nitride semiconductor light-emitting device of the present invention, preferably, the well layers include a gallium nitride semiconductor comprising indium as a group III constituent. The group III nitride semiconductor light-emitting device can emit light in a significantly broad range of wavelength.

Preferably, in the group III nitride semiconductor light-emitting device of the present invention, the well layers comprise In_{X}Ga_{1-X}N, the indium content X of the well layers may be equal to or more than 0.15. The group III nitride semiconductor light-emitting device can emit long-wavelength light. In combination with a hole-blocking layer of a quaternary mixed crystal, the well layers of high crystal quality can be grown even when its indium content is high.

The group III nitride semiconductor light-emitting device of the present invention may further include a gallium nitride based semiconductor layer provided between the hole-blocking layer and the n-type gallium nitride based semiconductor region. The gallium nitride based semiconductor layer comprises indium as a group III constituent, the band gap of the gallium nitride based semiconductor layer is less than that of the hole-blocking layer, and the band gap of the gallium nitride based semiconductor layer is less than that of the n-type gallium nitride based semiconductor region. This group III nitride semiconductor light-emitting device can reduce stress applied to the active layer that includes the well layers with a high indium content.

In the group III nitride semiconductor light-emitting device of the present invention, the active layer is prepared such that the device has a peak wavelength in a wavelength region of 450 nm or more. Furthermore, the active layer may be prepared so as to have a peak wavelength in a wavelength region of 650 nm or less.

Another aspect of the present invention provides an epitaxial wafer for a group III nitride semiconductor light-emitting device. The epitaxial wafer includes (a)an n-type gallium nitride based semiconductor region, (b) a hole-blocking layer, (c) an active layer, (d) an electron-blocking layer; and (e) a p-type gallium nitride based semiconductor region. The n-type gallium nitride based semiconductor region is provided on a primary surface of a substrate. The n-type gallium nitride based semiconductor region has a primary surface, and the primary surface extends along a predetermined plane. The c-axis of the n-type gallium nitride based semiconductor region tilts from a normal line of the predetermined plane. The hole-blocking layer is provided on the primary surface of the n-type gallium nitride based semiconductor region. The hole-blocking layer comprises a first gallium nitride based semiconductor, and the band gap of the hole-blocking layer is greater than that of the n-type gallium nitride based semiconductor region. The thickness of the hole-blocking layer is less than that of the n-type gallium nitride based semiconductor region. The active layer is provided on the hole-blocking layer. The band gap of the hole-blocking layer is greater than a maximum band gap of the active layer. The electron-blocking layer is provided on the active layer, and the electron-blocking layer comprises a second gallium nitride based semiconductor. The active layer is provided between the hole-blocking layer and the electron-blocking layer. The p-type gallium nitride based semiconductor region is provided on the electron-blocking layer.

In the epitaxial wafer, since the active layer is provided between the p-type gallium nitride based semiconductor region and the hole-blocking layer, the p-type gallium nitride based semiconductor region supplies the active layer with holes. Since the band gap of the hole-blocking layer is greater than that of the gallium nitride based semiconductor region, the hole-blocking layer functions as a barrier against holes in the active layer. Accordingly, the hole-blocking layer can reduce the leakage of holes that overflow from the active layer and reach the n-type gallium nitride based semiconductor region. Since the thickness of the hole-blocking layer is less than that of the n-type gallium nitride based semiconductor region, the hole-blocking layer does not exhibit high resistance to electron flow fed from the n-type gallium nitride based semiconductor region to the active layer.

Preferably, in the epitaxial wafer of the present invention, the substrate comprises GaN, the tilt angle defined by the c-axis of GaN of the substrate and the normal line of the primary surface of the substrate is in the range of 10 degrees to 80 degrees.

The above-described object and other objects, features, and advantages of the present invention will become apparent more easily in the detailed description of the preferred embodiments of the present invention which will be described below with reference to the accompanying drawings.

### Brief Description of the Drawings

Fig. 1 is a schematic view showing a structure of a group III nitride semiconductor light-emitting device according to an embodiment of the present invention;
Fig. 2 is a band diagram of the group III nitride semiconductor light-emitting device shown in Fig. 1;
Fig. 3 is a flow chart of primary steps of the method of fabricating a group III nitride semiconductor light-emitting device;
Fig. 4 is a flow chart of primary steps of the method of fabricating the group III nitride semiconductor light-emitting device;
Fig. 5 illustrates products in primary steps of the method shown in Figs. 3 and 4;
Fig. 6 is a cross-sectional view of the structure of a substrate product; and
Fig. 7 is a view showing graphs of electroluminescence spectra.

### Detailed Description of the Preferred Embodiments

The teachings of the present invention will readily be understood in view of the following detailed description with reference to the accompanying drawings illustrated by way of example. The embodiments of the group III nitride semiconductor light-emitting device and the epitaxial wafer of the present invention will now be described with reference to the attached drawings. When possible, parts identical to each other will be referred to with reference symbols identical to each other.

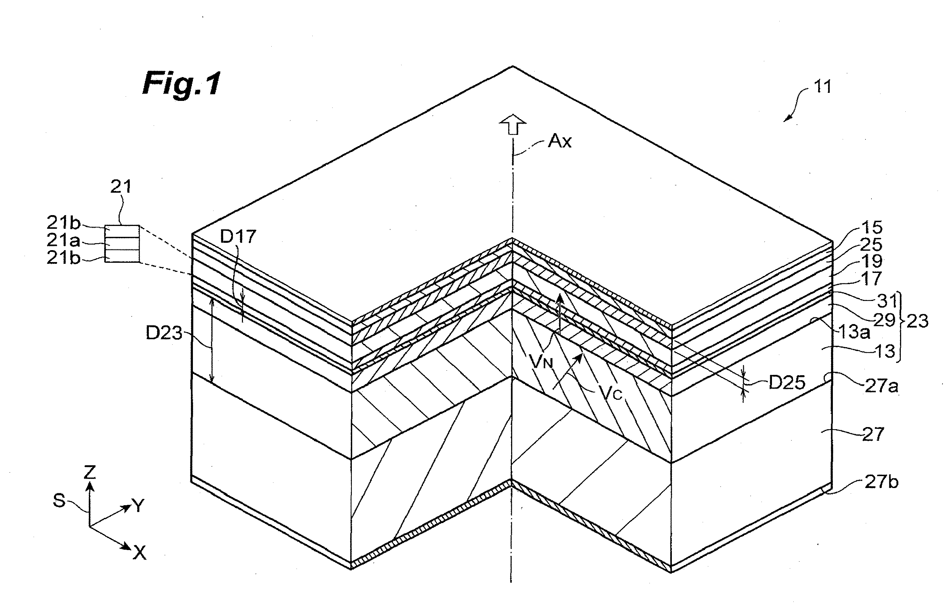

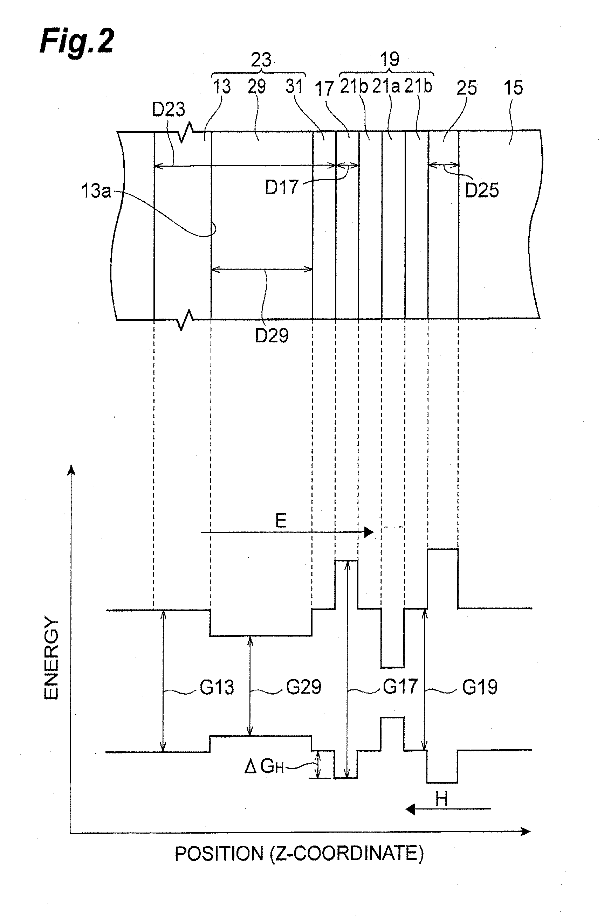

Fig. 1 is a schematic view showing the structure of a group III nitride semiconductor light-emitting device according to an embodiment of the present invention. With reference to Fig. 1, orthogonal coordinate system S for the group III nitride semiconductor light-emitting device 11 (hereinafter referred to as "light-emitting device") is depicted. Fig. 2 is a view showing a band diagram of the light-emitting device 11. The light-emitting device 11 may be, for example, a light emitting diode. The light-emitting device 11 includes a hexagonal n-type gallium nitride based semiconductor layer (hereinafter, referred to as "n-type GaN-based semiconductor layer") 13, a hexagonal p-type gallium nitride based semiconductor region (hereinafter, referred to as "p-type GaN-based semiconductor region") 15, a hole-blocking layer 17, and an active layer 19. The n-type GaN-based semiconductor layer 13 has a primary surface 13a extending along a predetermined plane. The hole-blocking layer 17 comprises a gallium nitride based semiconductor, for example, InAlGaN or AlGaN. The active layer 19 comprises a gallium nitride based semiconductor, and is provided between a p-type GaN based semiconductor region 15 and the hole-blocking layer 17. The hole-blocking layer 17 and the active layer 19 are provided between the primary surface 13a of the n-type GaN-based semiconductor layer 13 and the p-type GaN-based semiconductor region 15. The active layer 19 includes one or more semiconductor layers, and is provided on the hole-blocking layer 17. The gallium nitride based semiconductor region (hereinafter, referred to as "GaN-based semiconductor region") 23 has an n-conductivity type, and comprises a hexagonal crystal system. The GaN-based semiconductor region 23 may include one or more semiconductor layers. For example, the n-type GaN-based semiconductor layer 13 is included in the GaN-based semiconductor region 23. The GaN-based semiconductor region 23 supplies the active layer 19 with electrons whereas the p-type GaN-based semiconductor region 15 supplies the active layer 19 with holes. The c-axis of the n-type GaN-based semiconductor layer 13 (also, the GaN-based semiconductor region 23) tilts from the normal line of the predetermined plane, and the band gap G17 of the hole-blocking layer 17 is greater than the maximum band gap G19 of the active layer 19. The thickness D17 of the hole-blocking layer 17 is less than the thickness D23 of the GaN-based semiconductor region 23. The p-type GaN-based semiconductor region 15 may include, for example, a contact layer.

In the light-emitting device 11, the active layer 19 is provided between the p-type GaN-based semiconductor region 15 and the hole-blocking layer 17. Thus, holes H are fed from the p-type GaN-based semiconductor region 15 to the active layer 19. Since the band gap G17 of the hole-blocking layer 17 is greater than the largest of the band gap values of the semiconductor layers of the GaN-based semiconductor region 23, the hole-blocking layer 17 functions as a barrier of ΔG_{H} for the holes that overflow from the active layer 19. Thus, the hole-blocking layer 17 can reduce the leakage of holes that overflow from the active layer 19 and reach the GaN-based semiconductor region 23. Since the thickness D 17 of the hole-blocking layer 17 is less than the thickness D23 of the GaN-based semiconductor region 23, the hole-blocking layer 17 does not have high resistance to electrons E fed from the GaN-based semiconductor region 23 to the active layer 19.

With reference to Fig. 1, in the light-emitting device 11, a tilt angle defined by the c-axis vector Vc of the GaN-based semiconductor layer 13 and the normal axis V_{N} of the predetermined plane (or the primary surface of the GaN-based semiconductor region 23) may be equal to or more than 10 degrees. In this range of the tilt angle, the diffusion length of carriers, particularly holes, is large compared with the c-plane, a-plane, and m-plane; hence, the holes can readily overflow from the active layer to the n-type GaN region when a voltage is applied thereto. In addition, preferably the tilt angle may be equal to or less than 80 degrees. In this range of the tilt angle, the diffusion length of carriers, particularly holes, is large compared with the c-plane, a-plane and m-plane; hence, holes can readily overflow from the active layer to the n-type GaN region when a voltage is applied thereto.

Preferably in the light-emitting device 11, the thickness D17 of the hole-blocking layer 17 is 5 nm or more in order to prevent tunneling of holes from occurring in the hole-blocking layer 17. In addition, preferably the thickness D17 of the hole-blocking layer 17 is 50 nm or less. The hole-blocking layer 17 having such a thickness D17 does not exhibit high resistance to electrons E fed from the GaN-based semiconductor region 23 to the active layer 19, and can reduce stress that is caused by lattice mismatching and applied to the active layer. The hole-blocking layer 17 can be undoped, but it is preferable that the hole-blocking layer 17 be doped with an n-type dopant. Doping with an n-type dopant can reduce the resistance of the hole-blocking layer 17. For example, silicon (Si) and carbon (C) can be used as n-type dopant.

The light-emitting device 11 may further include an electron-blocking layer 25. The GaN-based semiconductor region 23, the hole-blocking layer 17, the active layer 19, the electron-blocking layer 25, and the p-type GaN-based semiconductor region 15 are arranged along a predetermined axis Ax. The electron-blocking layer 25 is located between the active layer 19 and the p-type GaN-based semiconductor region 15. The electron-blocking layer 25 comprises a gallium nitride based semiconductor, such as AlGaN or InAlGaN. For example, the thickness D17 of the hole-blocking layer 17 may be less than the thickness D25 of the electron-blocking layer 25. The active layer 19 is located between the hole-blocking layer 17 and the electron-blocking layer 25. The thickness D25 of the electron-blocking layer 25 is smaller than the thickness of the p-type GaN-based semiconductor region 15. The p-type GaN-based semiconductor region 15 is provided on the electron-blocking layer 25. The thickness of the electron-blocking layer 25 may be, for example, 5 nm or more and 30 nm or less.

The active layer 19 has a quantum well structure 21 that includes one or more well layers 21a and plural barrier layers 21b, which are alternately arranged. In the quantum well structure 21, it is preferable that the number of the well layers 21a be fallen within the range of one to four. An increase in the number of the well layers 21 a may lead to deterioration in crystal quality of the well layers 21a. This deterioration trend is noticeably observed in well layers formed on a semipolar surface. In an active layer having a large number of well layers, the application of bias inevitably forms a large thickness of the depletion layer in the active layer. This depletion layer increases an effective distance between the p-type region and the n-type region to reduce the effect of carrier overflow. On the other hand, a reduced number of well layers 21a leads to a small physical thickness of the active layer 19. Thus, emission characteristics are readily affected by overflow of holes. Accordingly, the range of the number of the well layers described above is preferred. For example, the thickness of each well layer 21 a may be 2 nm or more and 10 nm or less. For example, the thickness of each barrier layer 21b may be 10 nm or more and 30 nm or less. The total thickness of the active layer 19 may be 100 nm or less.

Preferably, in order to provide light emission in a wide wavelength range, the well layers 21 a are made of a gallium nitride based semiconductor containing indium as a group III constituent. More specifically, it is preferred that the well layers 21a be made of In_{X}Ga_{1-X}N, which has an indium content X of 0.15 or more. Within this range, the light-emitting device 11 can emit light of a long-wavelength range. Incorporation of a hole-blocking layer composed of a quaternary mixed crystal can achieve high crystal quality in InGaN well layers even with high indium content. Preferably, the indium content X in the well layers 21a is 0.40 or less. The barrier layers 21b may be composed of GaN, InGaN, or AlGaN.

The active layer 19 is provided such that the peak wavelength of photoluminescence (PL) and electroluminescence (EL) spectra resides in the region of 450 nm to 650 nm.

The light-emitting device 11 may further include a substrate 27. The substrate 27 comprises a gallium nitride based semiconductor and has a semipolar primary surface 27a and a rear surface 27b. The primary surface 27a tilts from the c-axis of the gallium nitride based semiconductor. This tilt angle may be 10 degrees or more and 80 degrees or less.

The GaN-based semiconductor region 23 is sandwiched between the substrate 27 and the hole-blocking layer 17. The GaN-based semiconductor region 23 has a pair of planes, which are opposite to each other. One plane of the GaN-based semiconductor region 23 is in contact with the primary surface 27a of the substrate 27 while the other plane is in contact with the hole-blocking layer 17. The light-emitting device 11 is formed on the semipolar primary surface 27a through epitaxial growth, and the behavior of holes inherent in the semipolar plane does not become noticeable in the light-emitting device 11. The substrate may comprise GaN or InGaN. When the substrate is made of GaN, the light-emitting device 11 can be produced using a semipolar GaN wafer having a large diameter.

Tilting of the primary surface of the substrate from the c-plane toward the m-plane can reduce the piezoelectric field, which is generated by strain applied to the well layer and caused by a difference in lattice constant between the well layers and the barrier layers. Tilting of the primary surface of the substrate from the c-plane toward the a-plane can reduce the piezoelectric field generated by strain which is applied to the well layers and caused by a difference in lattice constant between the well layers and the barrier layers.

The light-emitting device 11 may further include a gallium nitride based semiconductor layer (hereinafter, referred to as "GaN-based semiconductor layer") 29 containing indium as a group III constituent. The GaN-based semiconductor layer 29 is disposed between the hole-blocking layer 17 and the GaN-based semiconductor layer 13. The GaN-based semiconductor layer 29 may be made of, for example, InGaN. The band gap G29 of the GaN-based semiconductor layer 29 is less than the band gap G17 of the hole-blocking layer 17. The band gap G29 of the GaN-based semiconductor layer 29 is less than the band gap G13 of the GaN-based semiconductor layer 13. In the GaN-based semiconductor layer 29 having the above band gap, the well layers can be provided with high indium content while the active layer 19 can be provided with reduced strain.

The light-emitting device 11 may further include a gallium nitride based semiconductor layer (hereinafter, referred to as "GaN-based semiconductor layer") 31. The GaN-based semiconductor layer 31 is sandwiched between the GaN-based semiconductor layer 29 and the hole-blocking layer 17. The GaN-based semiconductor layer 31 may be made of, for example, GaN. The GaN-based semiconductor layer 31 can reduce the influence on the difference in lattice constant between the GaN-based semiconductor layer 29 and the hole-blocking layer 17. The thickness of the GaN-based semiconductor layer 31 is less than the thicknesses of the GaN-based semiconductor layer 29 and the n-type GaN-based semiconductor layer 13.

With reference to Fig. 2, the band gap G17 of the hole-blocking layer 17 is more than the maximum of the band gaps of the semiconductor layers that are included in the GaN-based semiconductor region 23 and are provided between the hole-blocking layer 17 and the substrate 27.

Preferably, the hole-blocking layer 17 comprises a gallium nitride based semiconductor containing gallium, indium, and aluminum as group III constituents. By using, for example, a quaternary mixed crystal (not ternary mixed crystal), the hole-blocking layer 17 blocks holes and ensures a lattice constant that can reduce stress to the active layer. For example, a hole-blocking layer 17 composed of a quaternary mixed crystal can reduce the stress to the active layer 19.

The hole-blocking layer 17 of InAlGaN contains aluminum as a group III constituent. When the hole-blocking layer 17 contains aluminum as a group III constituent, the band gap of the hole-blocking layer 17 is greater than that of GaN, and the hole-blocking layer 17 can function as a barrier to holes. The hole-blocking layer 17 having an aluminum content of 0.5 or less provides a high effect of barrier to holes, and reduces the difference in lattice constant between the hole-blocking layer 17 and the adjoining layer, leading to the less cracking therein.

The hole-blocking layer 17 of InAlGaN contains indium as a group III constituent, and preferably the indium content in the hole-blocking layer 17 may be greater than 0 and 0.3 or less. When the hole-blocking layer 17 that contains indium as a group III constituent has the same band gap as a hole-blocking layer not containing indium, the hole-blocking layer 17 has an increased lattice constant and achieves a small difference in lattice constant between the hole-blocking layer 17 and the barrier layers and well layers, resulting in the overall strain being reduced. When the hole-blocking layer 17 has an indium content of 0.3 or less, it is not necessary that an aluminum content of the hole-blocking layer 17 having the same band gap as above be an extremely high, resulting in easiness of its growth.

The hole-blocking layer 17 may include an AlGaN layer. AlGaN, in addition to InAlGaN, can also be used for the hole-blocking layer 17. AlGaN can provide a hole-blocking layer 17 having a high band gap.

The AlGaN hole-blocking layer 17 may contain aluminum as a group III constituent. The hole-blocking layer 17 having an aluminum content of 0.5 or less provides a high barrier to holes, and reduces the difference in lattice constant between the hole-blocking layer 17 and the adjoining layer, thereby preventing the occurrence of cracking therein.

In the light-emitting device 11, for example, in a light emitting diode, light L is emitted from the upper face of the light-emitting device 11. Since the light emitting diode does not include any optical cladding layer which semiconductor lasers have, the hole-blocking layer is effective in reducing overflow of holes.

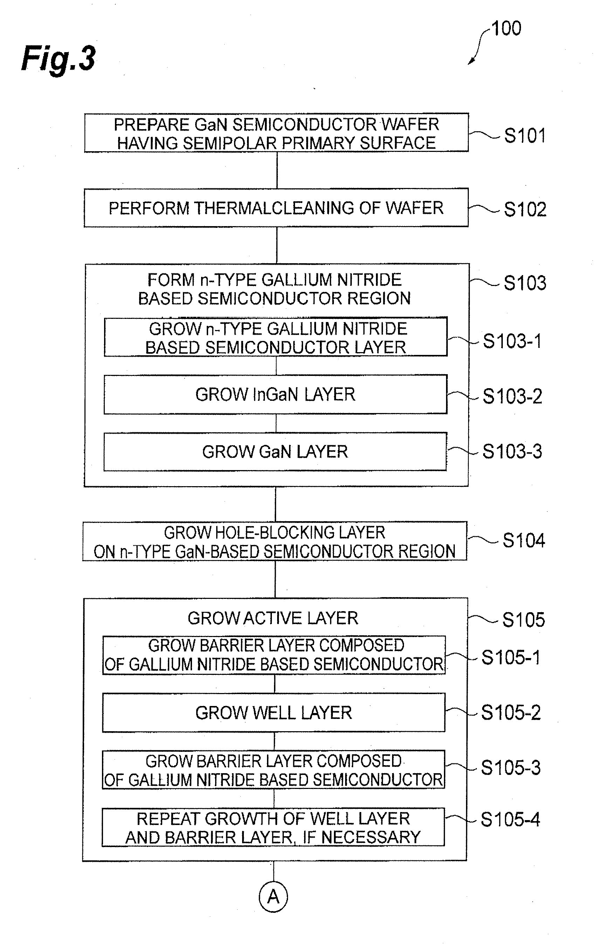

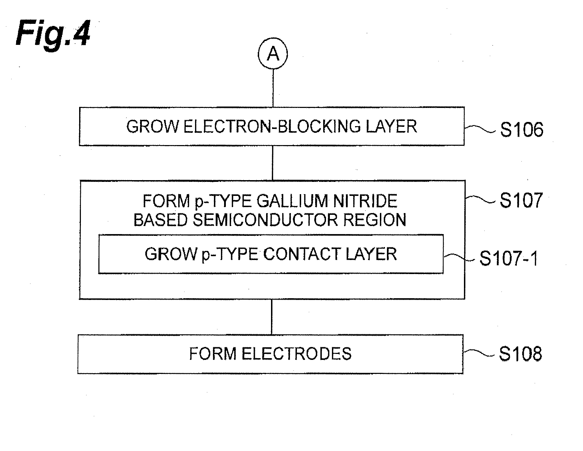

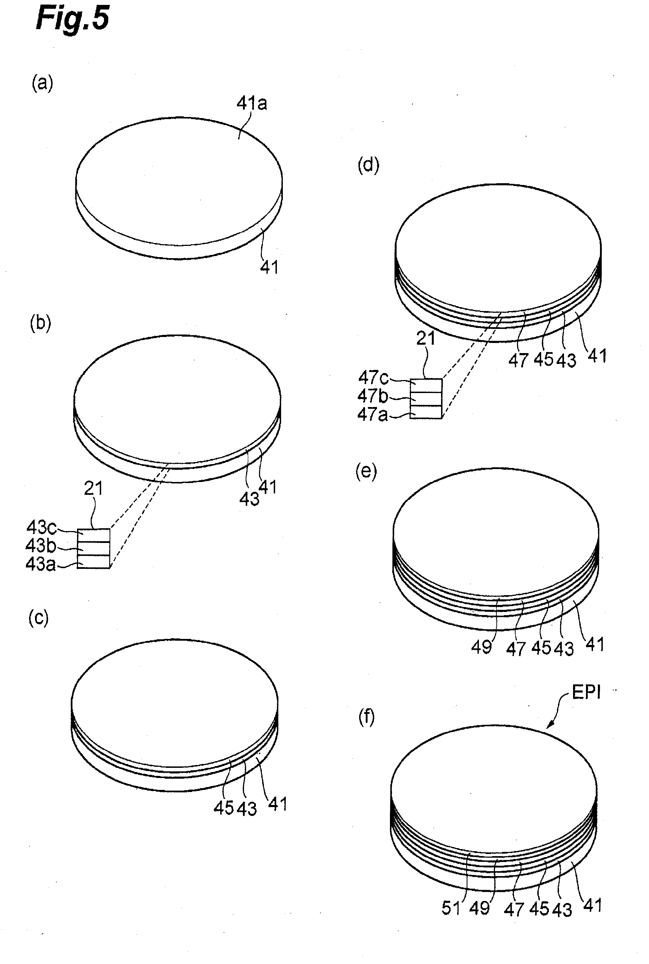

Figs. 3 and 4 illustrate primary steps of the method of fabricating a group III nitride semiconductor light-emitting device. Fig. 5 illustrates products in the primary steps shown in Figs. 3 and 4.

A blue light emitting diode was prepared by organometallic vapor phase epitaxy. Raw materials used were trimethylgallium (TMG), trimethylaluminium (TMA), trimethylindium (TMI), and ammonia (NH₃). Dopant gases used were silane (SiH₄) and bis-cyclopentadienyl magnesium (CP₂Mg).

Referring to Step 100, the fabrication of an epitaxial wafer is explained below. With reference to Part (a) of Fig. 5, in Step S101, a hexagonal semipolar gallium nitride wafer was prepared. The primary surface of the gallium nitride wafer is tilted by an angle of 10 to 80 degrees from the c-plane toward the m-plane or the a-plane. The size of the gallium nitride wafer is, for example, 2 inches or more. After loading the GaN wafer 41 in a reactor, in Step S102, the GaN wafer 41 was annealed for ten minutes at a temperature of 1100°C under a reactor pressure of 27 kPa while supplying a stream of NH₃ and H₂ to the reactor.

In Step S 103, as shown in Part (b) of Fig. 5, an n-type gallium nitride based semiconductor region 43 was epitaxially grown on the GaN wafer 41. In more detail, in Step S103-1, a Si-doped GaN layer 43a was grown at a substrate temperature of 1150°C. The GaN layer 43a has a thickness of, for example, 2 µm. After the substrate temperature was decreased to 780°C, in Step S 103-2, TMG, TMI, and SiH₄ were supplied to the reactor to perform the epitaxial growth of a Si-doped In_{0.04}Ga_{0.96}N buffer layer 43b. The In_{0.04}Ga_{0.96}N buffer layer 43b had a thickness of 100 nm. If necessary, after the substrate temperature was increased to 870°C, in Step S 103-3, a Si-doped GaN layer 43c was epitaxially grown thereon. The GaN layer 43c had a thickness of, for example, 10 nm.

In Step S104, after the substrate temperature was increased to 870°C, as shown in Part (a) of Fig. 5, a hole-blocking layer 45 was epitaxially grown thereon. The hole-blocking layer 45 was a Si-doped Al_{0.06}Ga_{0.94}N layer, and its thickness was 10 nm.

With reference to Part (d) of Fig. 5, in Step S 105, an active layer 47 was epitaxially grown thereon. More specifically, in Step S105-1, a GaN barrier layer 47a with a thickness of 10 nm was grown at a substrate temperature of 870°C. In Step S105-2, after the substrate temperature was decreased to 700°C, a 4-nm thick In_{0.25}Ga_{0.75}N well layer 47b was grown thereon. After the substrate temperature was increased to 870°C, in Step S105-3, a GaN barrier layer 47c with a thickness of 15 nm was grown thereon at a substrate temperature of 870°C. If necessary, in Step S 105-4, the growth of the well layer and the barrier layer is repeated.

In Step S106, the flow of TMG and TMI was stopped, and the substrate temperature was increased to 1100°C while ammonia was supplied. With reference to Part (e) of Fig. 5, TMG, TMA, NH₃, and CP₂Mg were then introduced into the reactor to epitaxially grow a Mg-doped p-type Al_{0.12}Ga_{0.88}N layer 49 with a thickness of 20 nm. With reference to Part (f) of Fig. 5, in Step S107, the flow of TMA was stopped not to supply it, and a 50-nm thick p-type GaN layer 51 was grown epitaxially. After the substrate temperature was decreased to room temperature, the epitaxial wafer EPI was removed from the reactor. In order to perform comparison with the advantage of the hole-blocking layer adjacent to the n-type layer, an LED structure without an n-type AlGaN layer (hole-blocking layer) was produced as in above.

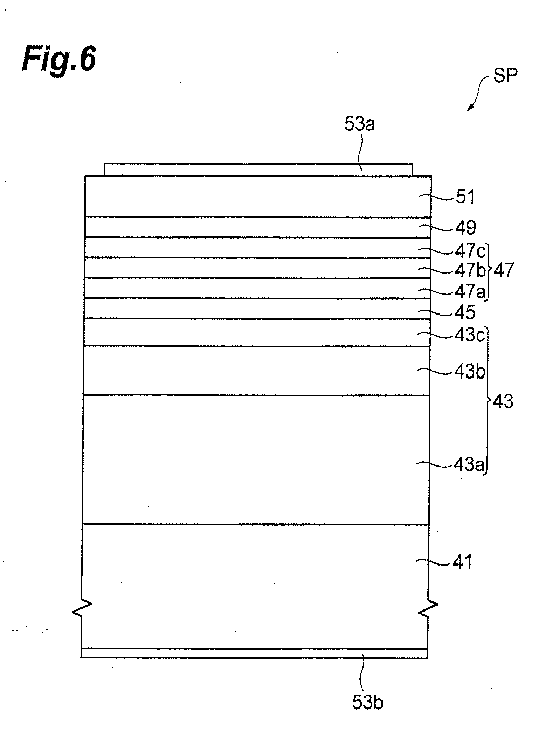

In Step S108, an anode 53a was formed on the p-type gallium nitride based semiconductor region so as to contact with the p-type contact layer 51 electrically. After the rear surface of the substrate was polished, a cathode 53b was formed; thereby producing a substrate product SP shown in Fig. 6. These electrodes were formed by vapor deposition.

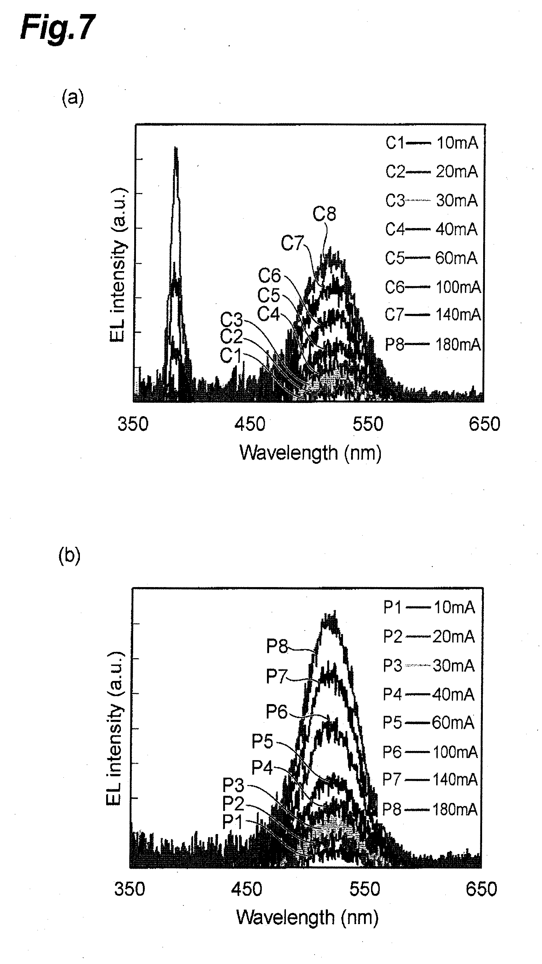

A current was applied to the substrate product SP for measurement of luminescence. Fig. 7 is graphs showing electroluminescence spectra. Part (a) of Fig. 7 shows characteristic curves C1 to C8 that correspond to 10 mA, 20 mA, 30 mA, 40 mA, 60 mA, 100 mA, 140 mA, and 180 mA, respectively, which are applied to the LED structure without a hole-blocking layer; while Part (b) of Fig. 7 shows characteristic curves P1 to P8 that correspond to 10 mA, 20 mA, 30 mA, 40 mA, 60 mA, 100 mA, 140 mA, and 180 mA, respectively, which are applied to the LED structure with a hole-blocking layer. Part (a) of Fig. 7 reveals that strong emission from the underlying buffer layer is observed in the LED structure without a hole-blocking layer, which suggests significant overflow of holes to the n side. In contrast, Part (b) of Fig. 7 reveals that strong emission from the well layers, not from the underlying buffer layer, is observed in the LED structure having a hole-blocking structure including an n-type AlGaN layer, which suggests that the block layer at the n-side provides the effective confinement of holes into the well layer and suppression of overflow of the holes from the well layers to the n-side region.

AlGaN has a small lattice constant, and thus there is a great difference in lattice constant between the layer of AlGaN and an InGaN active layer which has a large lattice constant. The AlGaN layer provided between the active layer and the substrate leads to an increase in stress applied to the active layer. This may results in low emission efficiency. In order to avoid such a disadvantage, the hole-blocking layer is preferably composed of an InAlGaN quaternary mixed crystal. The quaternary mixed crystal can have a composition that can achieve not only a sufficiently large band gap appropriate for the hole-blocking layer, but also reduce a difference in lattice constant between the well layers and the hole-blocking layer. As a result, both hole blocking and reduced strain in the well layers can be achieved. For example, InAlGaN quaternary mixed crystal is particularly suitable for a light emitting diode that includes an InGaN well layer having a high indium content and emits light in a long wavelength region of 500 nm or more.

In this embodiment, in the fabrication of the light-emitting diode structure on the off-angled substrate, the n-type AlGaN layer or n-type InAlGaN layer working as a hole-blocking layer is grown on the n-type layer side. A large hole diffusion length in the epitaxial layer on the off-angled substrate causes overflow of holes, which is not observed in a light-emitting diode structure formed on a polar surface.

The n-type hole-blocking layer on the off-angled substrate can prevent holes from overflowing from the well layers to the n-type layer in the application of current to ensure carrier injection into the well layer(s), resulting in high emission intensity due to improved internal quantum efficiency.

As described above, an aspect of the present invention provides a group III nitride semiconductor light-emitting device that can reduce overflow of holes from the active layer and thus exhibit improved quantum efficiency. Another aspect of the present invention provides an epitaxial wafer for the group III nitride semiconductor light-emitting device.

Having thus described and illustrated the principle of the invention in a preferred embodiment thereof, it is appreciated by those having skill in the art that the invention can be modified in arrangement and detail without departing from such principles. Details of structures of these devices or products can be modified as necessary. We therefore claim all modifications and variations coming within the spirit and scope of the following claims.

## Claims

1. A group III nitride semiconductor light-emitting device comprising:
an n-type gallium nitride based semiconductor region having a primary surface, the primary surface extending along a predetermined plane, a c-axis of the gallium nitride based semiconductor region tilting from a normal line of the predetermined plane;
a p-type gallium nitride based semiconductor region;
a hole-blocking layer comprising a first gallium nitride based semiconductor, a band gap of the hole-blocking layer being greater than that of the n-type gallium nitride based semiconductor region, and a thickness of the hole-blocking layer being less than that of the n-type gallium nitride based semiconductor region; and
an active layer comprising a gallium nitride based semiconductor, the active layer being provided between the p-type gallium nitride based semiconductor region and the hole-blocking layer, the hole-blocking layer and the active layer being provided between the primary surface of the n-type gallium nitride based semiconductor region and the p-type gallium nitride based semiconductor region, and a band gap of the hole-blocking layer being greater than a maximum band gap of the active layer.

2. The group III nitride semiconductor light-emitting device according to claim 1, wherein the tilt angle defined by the c-axis of the n-type gallium nitride based semiconductor region and the normal line of the predetermined plane is in an angle range of 10 degrees to 80 degrees.

3. The group III nitride semiconductor light-emitting device according to claim 1 or 2, wherein a thickness of the hole-blocking layer is equal to or more than 5 nanometers.

4. The group III nitride semiconductor light-emitting device according to any one of claims 1 to 3, wherein a thickness of the hole-blocking layer is equal to or less than 50 nanometers.

5. The group III nitride semiconductor light-emitting device according to any one of claims 1 to 4, wherein the hole-blocking layer is doped with an n-type dopant.

6. The group III nitride semiconductor light-emitting device according to any one of claims 1 to 5, wherein the first gallium nitride based semiconductor of the hole-blocking layer comprises gallium, indium and aluminum as group III constituents.

7. The group III nitride semiconductor light-emitting device according to any one of claims 1 to 6, wherein the first gallium nitride based semiconductor of the hole-blocking layer comprises indium as a group III constituent, and the indium content is in the range of greater than zero and equal to or less than 0.3.

8. The group III nitride semiconductor light-emitting device according to any one of claims 1 to 5, wherein the hole-blocking layer includes an AlGaN layer.

9. The group III nitride semiconductor light-emitting device according to any one of claims 1 to 8, wherein the first gallium nitride based semiconductor of the hole-blocking layer comprises aluminum as a group III constituent, and an aluminum content of the hole-blocking layer is in the range of more than zero and equal to or less than 0.5.

10. The group III nitride semiconductor light-emitting device according to any one of claims 1 to 9, further comprising an electron-blocking layer, the electron-blocking layer comprising a second gallium nitride based semiconductor, the electron-blocking layer being provided between the active layer and the p-type gallium nitride based semiconductor region, and a thickness of the hole-blocking layer being less than that of the electron-blocking layer.

11. The group III nitride semiconductor light-emitting device according to any one of claims 1 to 10, wherein the group III nitride semiconductor light-emitting device comprises a light emitting diode.

12. The group III nitride semiconductor light-emitting device according to any one of claims 1 to 11, further comprising a substrate, the substrate having a primary surface, the primary surface comprising a gallium nitride based semiconductor, the primary surface being semipolar, and the n-type gallium nitride based semiconductor region being provided between the substrate and the hole-blocking layer.

13. The group III nitride semiconductor light-emitting device according to any one of claims 1 to 12, wherein the substrate comprises GaN.

14. The group III nitride semiconductor light-emitting device according to any one of claims 1 to 13, wherein the active layer has a quantum well structure, the quantum well structure includes one or more well layers and barrier layers, and the number of the well layers is 4 or less.

15. The group III nitride semiconductor light-emitting device according to claim 14, wherein the well layers comprises a gallium nitride based semiconductor, and the gallium nitride semiconductor comprises indium as a group III constituent.

16. The group III nitride semiconductor light-emitting device according to claim 14 or 15, wherein the well layers comprise In_{X}Ga_{1-X}N, and the indium content X in the well layer is equal to or more than 0.15.

17. The group III nitride semiconductor light-emitting device according to any one of claims 1 to 16, further comprising a gallium nitride based semiconductor layer, the gallium nitride based semiconductor layer being provided between the hole-blocking layer and the n-type gallium nitride based semiconductor region, the gallium nitride based semiconductor layer comprising indium as a group III constituent, a band gap of the gallium nitride semiconductor layer being less than that of the hole-blocking layer, and a band gap of the gallium nitride based semiconductor layer being less than that of the n-type gallium nitride based semiconductor region.

18. The group III nitride semiconductor light-emitting device according to any one of claims 1 to 16, wherein the active layer is prepared such that the device emits light of a peak wavelength in a wavelength region of 450 nanometers or more.

19. An epitaxial wafer for a group III nitride semiconductor light-emitting device, comprising:
an n-type gallium nitride based semiconductor region provided on a primary surface of a substrate, the n-type gallium nitride based semiconductor region having a primary surface, the primary surface of the n-type gallium nitride based semiconductor region extending along a predetermined plane, and a c-axis of the gallium nitride based semiconductor region tilting from a normal line of the predetermined plane;
a hole-blocking layer provided on the primary surface of the n-type gallium nitride based semiconductor region, the hole-blocking layer comprising a first gallium nitride based semiconductor, a band gap of the hole-blocking layer being greater than that of the n-type gallium nitride based semiconductor region, and a thickness of the hole-blocking layer being less than that of the gallium nitride based semiconductor region;
an active layer provided on the hole-blocking layer, a band gap of the hole-blocking layer being greater than a maximum band gap of the active layer;
an electron-blocking layer provided on the active layer, the electron-blocking layer comprising a second gallium nitride based semiconductor, and the active layer being provided between the hole-blocking layer and the electron-blocking layer; and
a p-type gallium nitride based semiconductor region provided on the electron-blocking layer.

20. The epitaxial wafer according to claim 19, wherein the substrate comprises GaN, and a tilt angle defined by the c-axis of GaN of the substrate and a normal line of the primary surface of the substrate is in an angle range of 10 degrees to 80 degrees.
